# EUROPÄISCHE PATENTSCHRIFT

(11) **EP 1 933 362 B1**
(45) Veröffentlichungstag und Bekanntmachung des Hinweises auf die Patenterteilung: **13.04.2011**
(21) Anmeldenummer: 06025908.2
(22) Anmeldetag: 14.12.2006
(51) Int. Cl.: H01J 37/32

(54) **Bogenentladungs-Erkennungseinrichtung, Plasma-Leistungsversorgung und Verfahren zum Erkennen von Bogenentladungen**
Arc detection system, plasma power supply and arc detection method
Système de détection d'arc, alimentation de puissance pour appareil à plasma et procédé de détection d'arc

(43) Veröffentlichungstag der Anmeldung: 18.06.2008
(73) Patentinhaber: HÜTTINGER Elektronik GmbH + Co. KG, 79111 Freiburg (DE)
(72) Erfinder: Nitschke, Moritz, 79114 Freiburg (DE); Zähringer, Gerhard, 79112 Freiburg (DE)
(74) Vertreter: Kohler Schmid Möbus

(56) Entgegenhaltungen:
- EP-A2- 0 713 242
- US-A- 5 993 615
- US-A- 6 162 332
- US-B1- 6 943 317

## Beschreibung

Die Erfindung betrifft ein Verfahren zum Erkennen von Bogenentladungen in einem Plasmaprozess, bei dem zum Erkennen auftretender Bogenentladungen in dem Plasma mindestens eine Kenngröße des Plasmaprozesses überwacht wird und bei dem nach Erkennen einer Bogenentladung eine erste Gegenmaßnahme zum Unterdrücken von Bogenentladungen durchgeführt wird.

Weiterhin betrifft die vorliegende Erfindung eine Bogenentladungs-Erkennungseinrichtung zum Erkennen von Bogenentladungen in einem Plasmaprozess anhand mindestens einer Kenngröße des Plasmaprozesses, aufweisend: eine Überwachungseinheit zum Überwachen der mindestens einen Kenngröße, die zum Erzeugen und Ausgeben eines Überwachungssignals bei Erkennen einer Bogenentladung ausgebildet ist; und eine Steuereinheit, die dazu ausgebildet ist, in Abhängigkeit von dem Überwachungssignal wenigstens ein Steuersignal zum Steuern einer jeweiligen Gegenmaßnahme zum Unterdrücken der Bogenentladung zu erzeugen.

Darüber hinaus betrifft die vorliegende Erfindung auch eine Plasma-Leistungsversorgung zum Versorgen eines Plasmaprozesses.

Plasmaprozesse kommen beispielsweise in Plasmabearbeitungs- und Beschichtungsvorrichtungen vor. Mit Plasma kann weiterhin geätzt oder geascht werden. Ein sehr häufiger Plasmaprozess ist das so genannte Sputtern, bei dem mittels beschleunigter Ionen aus dem Plasma von einem Target Atome abgetragen werden, die sich auf einem Substrat ablagern. Beim Sputtern werden häufig reaktive Gase zugesetzt, um Verbundstoffe wie z.B. Al₂O₃ auf dem Substrat abzulagern Diese Art des Sputtens nennt man reaktives Sputtern. Beim reaktiven Sputtern kommt es zur Bildung von isolierenden Schichten auch auf dem Target. Die Ionen, die auf das Target beschleunigt werden, laden solche isolierenden Schichten auf. Übersteigt die Feldstärke einer so aufgeladenen isolierenden Schicht die Durchbruchfeldstärke, so kommt es zu Bogenentladungen, so genannten Arcs. Diese können kurz und selbstverlöschend sein (so genannte Short- oder Mikro-Arcs) oder aber lang andauernd und sehr energiereich sein (so genannte Hard-Arcs). Short-Arcs verursachen zumeist nur einen sehr geringen Schaden und können für viele Prozesse (z.B. Glasbeschichtung) zugelassen werden. Hard-Arcs führen in der Regel zur Zerstörung des Targets und zu nicht tolerierbaren Fehlstellen auf dem Substrat und werden daher in der Regel durch entsprechende Gegenmaßnahmen, wie nachfolgend beschrieben.

Um größeren Schaden von einer Sputteranlage fernzuhalten, wird die Stromzufuhr der Plasma-Leistungsversorgung nach dem Auftreten eines Hard-Arcs, kurzzeitig unterbrochen. Alternativ kann auch die Spannung an der Plasmakammer kurzgeschlossen oder umgepolt werden. Um die vorstehend genannten Maßnahmen zur Unterdrückung von Bogenentladungen einleiten zu können, sind für die Leistungsversorgung von Plasmaprozessen Einrichtungen zur Bogenentladungs-Erkennung oder Arc-Erkennung sowie zur Löschung der Bogenentladungen erforderlich und bilden oft einen Bestandteil der Plasmastromversorgung.

Da eine Unterbrechung der Plasma-Leistungsversorgung bzw. ein Umpolen derselben immer mit einer Beeinträchtigung des Durchsatzes des Plasmaprozesses verbunden ist und da es sich bei den erwähnten Short-Arcs um selbstverlöschende Bogenentladungen handelt, ist es eine weit verbreitete Ansicht, dass beim Betreiben eines Plasmaprozesses hinsichtlich Short-Arcs vorteilhafter Weise keine Gegenmaßnahmen ergriffen werden sollten. Da jedoch auch selbstverlöschende Arcs sich negativ auf ein Bearbeitungsergebnis des Plasmaprozesses auswirken und sich darüber hinaus ohne entsprechende Gegenmaßnahmen zu Hard-Arcs entwickeln können, hat sich ein derartiger Ansatz als nachteilig erwiesen.

Bei dem vorbekannten Verfahren ist demnach insbesondere als nachteilig anzusehen, dass auf selbstverlöschende Bogenentladungen überhaupt nicht reagiert wird. Wie bereits vorstehend angesprochen, ist dies mit den steigenden Anforderungen an Überarbeitungsqualität bei Plasmaprozessen, beispielsweise an die Qualität einer Beschichtung, nicht vereinbar.

Wenn eine Reaktion auf Short-Arcs jedoch in genau derselben Weise hinsichtlich Dauer und Intensität erfolgte wie bei Hard-Arcs, die naturgemäß häufig stärkere Gegenmaßnahmen erfordern, wäre die Plasma-Leistungsversorgung während unangemessen langer Zeiträume nicht aktiv, was zu einer deutlichen Verringerung der Bearbeitungsrate führen würde.

Aus der WO 2006/014212 A2 ist ein Verfahren zum Erkennen und zum Behandeln von Bogenentladungen bekannt, bei dem ein Leistungsfluss von einer Stromversorgung schon in einem Plasma für eine vorgestellte Zeit unterbrochen und anschließend wiederhergestellt wird. Wird anschließend erneut eine Bogenentladung erkannt, erfolgt eine erneute Unterbrechung des Leistungsflusses. Eine derartige Vorgehensweise wird von den Gegebenheiten in Plasmaprozessen vielfach nicht gerecht.

Insbesondere erfolgt dabei keine echte Unterscheidung zwischen Short-Arcs und Hard-Arcs, so dass beim Auftreten eines Hard-Arc wiederholt immer nur mit möglichst kurzen Unterbrechungen des Leistungsflusses reagiert wird, die jedoch einen Hard-Arc unter Umständen nicht löschen können und zu einer wiederholten Lieferung von Leistung in den Hard-Arc führen, wobei der Leistungsflusses unmittelbar nach erkennen des Hard-Arc wieder unterbrochen wird. Dies wirkt sich auf die Dauer negativ auf eine Bearbeitungsrate des Plasmaprozesses aus, wenn ein Hard-Arc auf diese Weise nicht sicher gelöscht werden kann.

Der Erfindung liegt die Aufgabe zugrunde, ein Verfahren, eine Bogenentladungs-Erkennungseinrichtung und eine Plasma-Leistungsversorgung der jeweils eingangs genannten Art dahingehend weiterzuentwickeln, dass sie steigenden Anforderungen an die Bearbeitungsqualität gerecht werden, ohne dass eine Bearbeitungsrate über Gebühr beeinträchtigt wird.

Gemäß einem ersten Aspekt der vorliegenden Erfindung wird diese Aufgabe bei einem Verfahren der eingangs genannten Art dadurch gelöst, dass nach Beendigung der ersten Gegenmaßnahme während einer variablen Verzögerungszeit abgewartet und anschließend in dem Fall, dass nach Ablauf der variablen Verzögerungszeit eine Bogenentladung erkannt wird, eine zweite Gegenmaßnahme zum Unterdrücken von Bogenentladungen durchgeführt wird.

Gemäß einem zweiten Aspekt der vorliegenden Erfindung wird die Aufgabe bei einer Bogenentladungs-Erkennungseinrichtung der eingangs genannten Art dadurch gelöst, dass die Steuereinheit dazu ausgebildet ist, nach Beendigung einer ersten Gegenmaßnahme während einer variablen Verzögerungszeit abzuwarten und nach Ablauf der variablen Verzögerungszeit in Abhängigkeit von dem Überwachungssignal ein Steuersignal zum Steuern einer zweiten Gegenmaßnahme zu erzeugen.

Im Kontext der vorliegenden Beschreibung bedeutet der Ausdruck "variabel", dass ein entsprechender Wert, wie eine zeitliche Dauer, nicht fest vorgegeben beziehungsweise fest eingestellt sondern im Verlaufe eines Verfahrens oder bei der Verwendung einer Vorrichtung veränderbar ist, sei es automatisch in Abhängigkeit von bestimmten Prozessparametern oder explizit durch Eingabe (Steuerung) seitens eines Anwenders. Darin liegt ein besonderer Vorteil dieser Erfindung. Vorbekannte Bogenentladungs-Erkennungseinrichtungen waren in dieser Hinsicht beschränkt und boten dem Anwender keine Möglichkeiten, Zeiten - wie insbesondere die Verzögerungszeit - variabel zu einzustellen. Mit der vorliegenden Erfindung hat der Anwender die Möglichkeit, die Bogenentladungs-Erkennungseinrichtung in vielfacher Hinsicht besser auf seine Prozesse abzustimmen und die Bearbeitungsrate sowie die Bearbeitungsqualität gleichzeitig hoch zu halten.

Gemäß einem dritten Aspekt der vorliegenden Erfindung wird die Aufgabe bei einer Plasma-Leistungsversorgung der genannten Art gelöst durch eine Bogenentladungs-Erkennungseinrichtung nach dem zweiten Aspekt der vorliegenden Erfindung, wobei die Plasma-Leistungsversorgung durch die Steuereinheit der Bogenentladungs-Erkennungseinrichtung steuerbar ist. Entsprechend ist in Weiterbildung des erfindungsgemäßen Verfahrens vorgesehen, dass das Verfahren zum Steuern des Betriebs einer Plasma-Leistungsversorgung eingesetzt wird.

Nach einem Grundgedanken der vorliegenden Erfindung wird somit in jedem Fall, d.h. auch im Falle von selbstverlöschenden Bogenentladungen eine erste Gegenmaßnahme zum Unterdrücken von Bogenentladungen bewirkt, wodurch die Erfindung steigenden Anforderungen an die Bearbeitungsqualität bei Plasmaprozessen gerecht wird. Allerdings wird eine derartige Gegenmaßnahme erfindungsgemäß nur dann vorgenommen oder eingeleitet, wenn zuvor tatsächlich eine (selbstverlöschende) Bogenentladung erkannt wurde. Anschließend wird nach Beendigung der ersten Gegenmaßnahme während einer variablen Verzögerungszeit, die vorliegend auch als "erste Zeit" bezeichnet wird und die bei bevorzugten Ausgestaltungen der vorliegenden Erfindung automatisch in Abhängigkeit von Prozessparametern des Plasmaprozesses oder alternativ durch einen Anwender einstellbar sein kann, abgewartet, so dass auf diese Weise zwischen Short-Arcs und Hard-Arcs unterschieden werden kann. Anschließend kann erfindungsgemäß mit der zweiten Gegenmaßnahme auf einem noch immer anliegenden Arc (Hard-Arc) reagiert werden.

Im Zuge entsprechende Weiterbildungen der vorliegenden Erfindung sind die ersten und zweiten Gegenmaßnahmen hinsichtlich ihrer Dauer, Intensität oder dergleichen zum Löschen von Short-Arcs beziehungsweise Hard-Arcs ausgebildet.

Bei der überwachten Kenngröße kann es sich in Weiterbildung sowohl des erfindungsgemäßen Verfahrens als auch der erfindungsgemäßen Bogenentladungs-Erkennungseinrichtung um eine elektrische Kenngröße des Plasmaprozesses handeln, wie eine Spannung oder eine Stromstärke.

Es ist erfindungsgemäß insbesondere auch möglich, die erste Gegenmaßnahme nach Maßgabe einer Überwachung einer ersten Kenngröße des Plasmaprozesses und die zweite Gegenmaßnahme nach Maßgabe einer Überwachung einer zweiten, von der ersten Kenngröße verschiedenen Kenngröße des Plasmaprozesses zu steuern.

In Weiterbildung des erfindungsgemäßen Verfahrens ist vorgesehen, dass als erste Gegenmaßnahme ein Unterbrechen oder ein Umpolen der Plasma-Leistungsversorgung durchgeführt wird. Dabei kann die erste Gegenmaßnahme insbesondere während einer zweiten Zeit durchgeführt werden, die darüber hinaus wie die erste Zeit variabel sein kann.

Im Zuge einer entsprechenden Ausgestaltung der erfindungsgemäßen Plasma-Leistungsversorgung ist vorgesehen, dass als erste Gegenmaßnahme nach Maßgabe des ersten Steuersignals die Plasma-Leistungsversorgung während einer bestimmten Zeit abschaltbar oder umpolbar ist, insbesondere während der zweiten Zeit. Die Steuereinheit der erfindungsgemäßen Bogenentladungs-Erkennungseinrichtung ist daher im Zuge einer entsprechenden Weiterbildung zum Ausgeben eines ersten Steuersignals zum Steuern der ersten Gegenmaßnahme während einer zweiten Zeit ausgebildet.

Um - wie gesagt - eine möglichst geringe Beeinträchtigung der Bearbeitungsrate des Plasmaprozesses zu gewährleisten, sieht eine andere Weiterbildung des erfindungsgemäßen Verfahrens vor, dass die erste Gegenmaßnahme zur Unterdrückung/Löschung von Short-Arcs nur kurzzeitig durchgeführt wird, d.h. dass die zweite Zeit zwischen 0,01 und 10 µs beträgt.

Gemäß einer entsprechenden Weiterbildung der erfindungsgemäßen Bogenentladungs-Erkennungseinrichtung ist vorgesehen, dass die zweite Zeit einstellbar ist und insbesondere zwischen 0,01 und 10 µs beträgt.

Vorteilhafter Weise kann bei einer Ausgestaltung des erfindungsgemäßen Verfahrens vorgesehen sein, dass als zweite Gegenmaßnahme ein Unterbrechen oder ein Umpolen der Plasma-Leistungsversorgung durchgeführt wird, wobei die zweite Gegenmaßnahme im Zuge einer anderen Weiterbildung des erfindungsgemäßen Verfahrens während einer dritten Zeit durchgeführt wird. In diesem Zusammenhang sieht eine weitere Ausgestaltung des erfindungsgemäßen Verfahrens vor, dass die dritte Zeit länger als die zweite Zeit ist und vorzugsweise mehr als 10 µs beträgt. Dabei kann die dritte Zeit ebenso wie die erste Zeit und die zweite Zeit variabel sein.

Eine entsprechende Weiterbildung der erfindungsgemäßen Plasma-Leistungsversorgung sieht vor, dass als zweite Gegenmaßnahme nach Maßgabe des zweiten Steuersignals die Plasma-Leistungsversorgung während einer weiteren vorbestimmten Zeit abschaltbar oder umpolbar ist, insbesondere während der dritten Zeit. Dabei kann die dritte Zeit in Weiterbildung der erfindungsgemäßen Bogenentladungs-Erkennungseinrichtung einstellbar sein, insbesondere auf Werte größer als die zweite Zeit.

Gemäß einer anderen Ausgestaltung des erfindungsgemäßen Verfahrens kann vorgesehen sein, dass während der Verzögerungszeit oder ersten Zeit keine Reaktion auf weitere erkannte Bogenentladungen erfolgt. Treten nämlich während der Zeit nach dem Erkennen einer ersten Bogenentladung bis zum Ablauf der genannten ersten Zeit noch weitere Bogenentladungen auf, brauchen diese erfindungsgemäß nicht berücksichtigt zu werden. Sollte nämlich - wie vorstehend beschrieben - nach Ablauf der ersten Zeit die Bogenentladung noch immer anliegen, wird diese ohnehin als Hard-Arc behandelt und mit einer entsprechend angepassten zweiten Gegenmaßnahme unterdrückt. Wenn jedoch die erste bekannte Bogenentladung nach Ablauf der ersten Zeit nicht mehr anliegt, bereinigt das gemäß einer Ausgestaltung der vorliegenden Erfindung vorgesehene kurze Abschalten bzw. Umpolen (d.h. die erste Gegenmaßnahme) auch alle "Unreinheiten" der zwischenzeitlich weiter aufgetretenen Bogenentladungen.

Um das erfindungsgemäße Verfahren hinsichtlich des Bearbeitungsdurchsatzes weiter zu verbessern, kann in Weiterbildung des erfindungsgemäßen Verfahrens auch vorgesehen sein, dass während einer jeweiligen vierten Zeit keine weiteren ersten und/oder zweiten Gegenmaßnahmen durchgeführt werden.

Entsprechend kann in Weiterbildung der erfindungsgemäßen Bogenentladungs-Erkennungseinrichtung vorgesehen sein, dass die Steuereinheit dazu ausgebildet ist, das erste Steuersignal und/oder das zweite Steuersignal vor Ablauf einer jeweiligen vierten Zeit nicht erneut zu erzeugen. Dabei kann die vierte Zeit einstellbar sein.

Bei einer anderen Ausgestaltung der erfindungsgemäßen Bogenentladungs-Erkennungseinrichtung ist die vierte Zeit für die ersten und zweiten Gegenmaßnahmen unabhängig voneinander einstellbar. Das Einstellen der vierten Zeit beziehungsweise der vierten Zeiten kann - wie auch das Einstellen der Verzögerungszeit (ersten Zeit) sowie der zweiten und dritten Zeiten - alternativ in Abhängigkeit von Prozessparametern des Plasmaprozesses automatisch oder durch eine entsprechende Eingabe seitens eines Anwenders geschehen.

Durch das Vorgeben bzw. Einstellen der vierten Zeit(en), innerhalb derer auf mehrere (zusätzlich) erkannte Arcs nicht reagiert wird, lässt sich die Bearbeitungsrate des Plasmaprozesses optimal anpassen und ggf. weiter erhöhen.

Eine andere Weiterbildung des erfindungsgemäßen Verfahrens zeichnet sich dadurch aus, dass die ersten und zweiten Gegenmaßnahmen von verschiedenen Bogenentladung-Löschungsschaltkreisen durchgeführt werden. Entsprechend kann in Weiterbildung der erfindungsgemäßen Bogenentladungs-Erkennungseinrichtung vorgesehen sein, dass diese getrennte Bogenentladung-Löschungsschaltkreise zum Bewirken der ersten und zweiten Gegenmaßnahmen aufweist. Auf diese Weise lässt sich auch hardwaremäßig eine optimal angepasste Reaktion auf unterschiedliche Typen von Bogenentladungen erreichen.

Des Weiteren kann bei einer anderen Ausgestaltung des erfindungsgemäßen Verfahrens vorgesehen sein, dass die ersten und zweiten Gegenmaßnahmen jeweils nach Ablauf einer variablen Reaktionszeit ab Erkennen einer Bogenentladung durchgeführt werden. Mit anderen Worten: die jeweilige Gegenmaßnahme wird nicht unmittelbar bei Erkennen einer Bogenentladung sondern erst nach Verstreichen der jeweiligen Reaktionszeit durchgeführt. Das Vorsehen einer solchen zusätzlichen variablen Reaktionszeit ist in Plasmaprozessen zum Erzielen eines optimalen Bearbeitungsergebnisses oftmals günstig.

Bei einer entsprechenden Weiterbildung der erfindungsgemäßen Bogenentladungs-Erkennungseinrichtung ist vorgesehen, dass die Steuereinheit zum Veranlassen der ersten und zweiten Gegenmaßnahmen jeweils nach Ablauf einer variablen Reaktionszeit ab Erkennen einer Bogenentladung ausgebildet ist.

Weiterhin kann auch die jeweilige Reaktionszeit automatisch in Abhängigkeit von Prozessparametern des Plasmaprozesses oder durch einen Anwender einstellbar sein.

Weitere Merkmale und Vorteile der Erfindung ergeben sich aus der nachfolgenden Beschreibung von Ausführungsbeispielen der Erfindung, anhand den Figuren der Zeichnung, die erfindungswesentliche Einzelheiten zeigen, und aus den Ansprüchen. Die einzelnen Merkmale können je einzeln für sich oder zu mehreren in beliebiger Kombination bei einer Variante der Erfindung verwirklicht sein.

Bevorzugte Ausführungsbeispiele der Erfindung sind in der Zeichnung schematisch dargestellt und werden nachfolgend mit Bezug zu den Figuren der Zeichnung näher erläutert. Es zeigt:
- **Fig. 1**: ein schematisches Blockschaltbild einer Ausgestaltung der erfindungsgemäßen Leistungsversorgung für einen Plasmaprozess;
- **Fig. 2**: ein Zeitablaufdiagramm für Signale innerhalb der Plasma-Leistungsversorgung aus Fig. 1; und
- **Fig. 3**: ein Flussdiagramm zur Darstellung einer Ausgestaltung des erfindungsgemäßen Verfahrens zum Erkennen von Bogenentladungen.

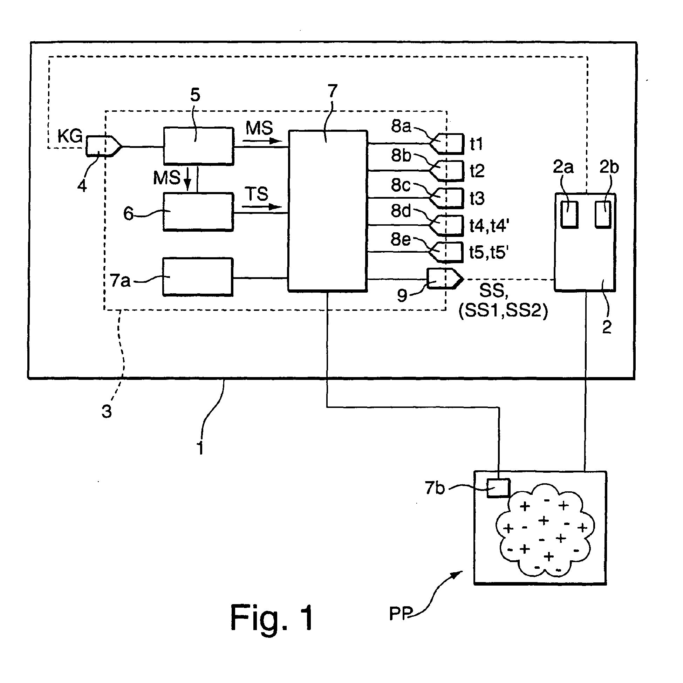

Fig. 1 zeigt ein schematisches Blockschaltbild einer Ausgestaltung der erfindungsgemäßen Leistungsversorgung für einen Plasmaprozess (Plasma-Leistungsversorgung). Die Plasma-Leistungsversorgung 1 gemäß Fig. 1 weist zunächst die eigentliche Leistungsquelle 2 zum Versorgen des Plasmaprozesses PP mit einer Gleichspannung oder Wechselspannung sowie eine Bogenentladungs-Erkennungseinrichtung 3 auf, die zum Erkennen von Bogenladungen in dem Plasmaprozess PP signaltechnisch mit der Leistungsquelle 2 innerhalb der Plasma-Leistungsversorgung 1 zusammenwirkt.

Dazu weist die Bogenentladungs-Erkennungseinrichtung 3 einen ersten Eingang 4 für eine Kenngröße KG der Leistungsquelle 2 auf. Wie dem Fachmann an sich geläufig ist, kann es sich bei der Kenngröße KG um eine Spannung oder einen Strom handeln, d.h. um eine elektrische Kenngröße, wobei ein Spannungsabfall bzw. eine Stromerhöhung an der Leistungsquelle 2 anzeigt, dass in dem Plasmaprozess PP eine Bogenentladung stattfindet oder zumindest im Entstehen begriffen ist. Auch die Messung einer Leistungs-Kenngröße kann hier gemeint sein, wie sie vor allem bei HF (Hochfrequenz)-Plasma-Leistungsversorgungen eingesetzt wird, beispielsweise einer Vorwärtsleistung P_{I} und einer Rückwärtsleistung P_{R}. Es ist auch möglich, eine externe Kenngröße oder Kombinationen von Kenngrößen zur Bogenentladungserkennung heranzuziehen.

Die Leitungsquelle 2 umfasst erste und zweite Bogenentladung-Löschungsschaltkreise 2a, 2b, auf die weiter unten noch genauer eingegangen wird.

Die Bogenentladungs-Erkennungseinrichtung 3 umfasst weiterhin eine Überwachungseinheit 5, die signaltechnisch mit dem Eingang 4 verbunden ist. Darüber hinaus weist die Bogenentladungs-Erkennungseinrichtung 3 eine Timer-Einheit 6 sowie eine Steuereinheit 7 auf, die mit einem Speichermittel 7a zusammenwirkt, d.h. auf dieses zugreifen kann. Die Steuereinheit 7 besitzt gemäß der Darstellung in Fig. 1 weitere Eingänge 8a - e sowie einen Ausgang 9. Über den Ausgang 9 ist die Steuereinheit 7 und damit die Bogenentladungs-Erkennungseinrichtung 3 mit der bereits erwähnten Leistungsquelle 2 signaltechnisch verbunden. Entsprechende Verbindungen bestehen auch zwischen der Überwachungseinheit 5 und der Timer-Einheit 6 sowie von der Überwachungseinheit 5 und der Timer-Einheit 6 zur Steuereinheit 7.

Darüber hinaus weist die Steuereinheit 7 noch eine Sensoranordnung 7b zum Bestimmen von Prozessparametern des Plasmaprozesses PP auf beziehungsweise ist mit einer solchen Anordnung in Wirkverbindung mit dem Plasmaprozess PP verbunden. Die Sensoranordnung 7b kann zusätzlich oder alternativ auch zur Erkennung von Bogenentladungen genutzt werden. Sie kann zu diesem Zweck der Überwachungseinheit 5 zugeordnet sein.

Erfindungsgemäß ist die Überwachungseinheit 5 der Bogenentladungs-Erkennungseinrichtung 3 dazu ausgebildet, die bei 4 eingegebene elektrische Kenngröße KG der Leistungsquelle 2 zu überwachen, beispielsweise durch Vergleichen mit einem (nicht gezeigten) Referenz- oder Schwellwert, was dem Fachmann an sich geläufig ist. Somit kann die Überwachungseinheit 5 insbesondere dazu ausgebildet sein, einen Abfall der Spannung der Leistungsquelle 2 bzw. einem Anstieg des Stroms der Leistungsquelle 2 durch Vergleich mit einem entsprechenden Referenzwert zu erkennen, was dementsprechend das Vorhandensein oder die Entstehung einer Bogenentladung des Plasmaprozesses anzeigt. Die Überwachungseinheit 5 ist weiterhin dazu ausgebildet, bei Erkennen einer Bogenentladung, wie vorstehend beschrieben, ein entsprechendes Überwachungssignal MS zu erzeugen und insbesondere an die Timer-Einheit 6 auszugeben. Des Weiteren erfolgt die Ausgabe des Überwachungssignals MS bei Erkennen der Bogenentladung auch an die Steuereinheit 7, wie in Fig. 1 dargestellt.

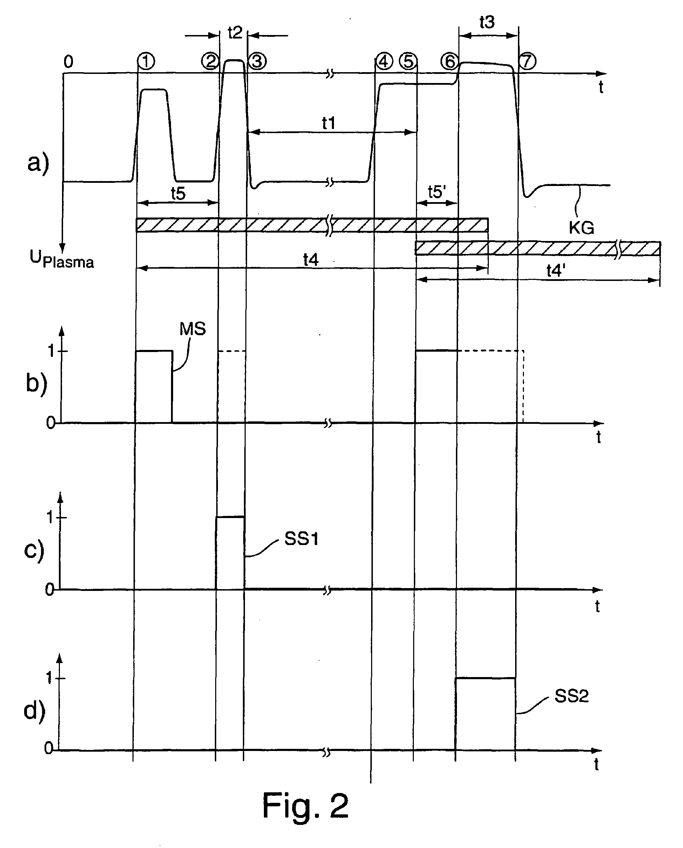

Es sei an dieser Stelle angemerkt, dass im Rahmen der vorliegenden Beschreibung der Begriff "Erzeugen" eines Signals ohne Beschränkung der Allgemeinheit angibt, dass das betreffende Signal auf einen hohen Logikpegel ("1") umgeschaltet wird. Wie der Fachmann erkennt, lässt sich der erfinderische Gedanke jedoch auch mittels alternativer Signalformen verwirklichen, insbesondere indem die betreffenden Signale bei ihrer Erzeugung zumindest teilweise auf einen niedrigen Logikpegel umgeschaltet werden. Hierauf wird weiter unten unter Bezugnahme auf die Figur 2 noch detaillierter eingegangen.

Die Timer-Einheit 6 ist vorliegend insbesondere dazu ausgebildet, eine seit Erzeugung des Überwachungssignals MS durch die Überwachungseinheit 5 vergangene Zeit zu bestimmen und das Zeitsignal TS an die Steuereinheit 7 auszugeben, wie in Fig. 1 dargestellt. Somit ist der Steuereinheit 7 nach Maßgabe des Überwachungssignals MS der Überwachungseinheit 5 und des Zeitsignals TS der Timer-Einheit 6 bekannt, ob und gegebenenfalls seit wann in dem Plasmaprozess eine Bogenentladung stattfindet oder in der Entstehung begriffen ist.

Die Steuereinheit 7 ist erfindungsgemäß ihrerseits dazu ausgebildet, in Abhängigkeit von dem anliegenden Überwachungssignal MS und der nach Maßgabe des Zeitsignals TS vergangenen Zeit seit Erkennen einer Bogenentladung wenigstens ein Steuersignal SS zu erzeugen und über den Ausgang 9 zum Steuern der Plasma-Leistungsversorgung 1 hinsichtlich einer betreffenden Gegenmaßnahme zur Unterdrückung der Bogenentladung an die Leistungsquelle 2 auszugeben. Dabei kann es sich bei dem Steuersignal SS insbesondere um ein Signal handeln, durch welches ein Abschalten oder ein Umpolen der Leistungsquelle 2 bewirkbar ist, um auf diese Weise in an sich bekannter Weise eine erkannte Bogenentladung des Plasmaprozesses zu unterdrücken (löschen). Dabei kommen in der Leistungsquelle 2 die bereits erwähnten Bogenentladung-Löschungsschaltkreise 2a, 2b zum Einsatz, die bei entsprechender Aktivierung durch das mindestens eine Steuersignal SS für ein Abschalten oder Umpolen der Leistungsquelle 2 sorgen.

Die Timer-Einheit 6 ist vorliegend weiterhin insbesondere dazu ausgebildet, eine seit Erzeugung des wenigstens einen Steuersignals SS durch die Steuereinheit 7 vergangene Zeit zu bestimmen. Somit ist erfindungsgemäß bekannt, ob und gegebenenfalls seit wann bzw. bis wann durch die Steuereinheit 7 Gegenmaßnahmen zum Unterdrücken einer Bogenentladung in dem Plasmaprozess veranlasst werden/wurden. Alternativ kann eine der Timer-Einheit 6 funktional entsprechende Einheit auch direkt in die Steuereinheit 7 integriert sein.

Um in der Praxis ein sicheres Löschen sowohl von selbstverlöschenden Short-Arcs als auch von nicht selbstverlöschenden Hard-Arcs realisieren zu können, ohne dabei eine Bearbeitungsrate des Plasmaprozesses PP übermäßig zu beeinträchtigen, ist die Steuereinheit 7 speziell dazu ausgebildet, ein erstes Steuersignal SS1 für eine erste Gegenmaßnahme zu erzeugen und über den Ausgang 9 an die Leistungsquelle 2 beziehungsweise den ersten Bogenentladung-Löschungsschaltkreis 2a auszugeben, wenn die Überwachungseinheit 5 das Überwachungssignal MS, welches das Erkennen einer Bogenentladung anzeigt, ausgibt. Vorzugsweise wird das erste Steuersignal SS1 erst nach Ablauf einer vorgegebenen ersten Reaktionszeit t5, die durch das Zeitsignal TS der Timer-Einheit 6 angezeigt wird, ausgegeben. Mit anderen Worten: Wenn das Zeitsignal TS der Timer-Einheit 6 den Ablauf einer vorgegebenen Reaktionszeit anzeigt, gibt die Steuereinheit 7 über den Ausgang 9 das erste Steuersignal SS1 an die Leistungsquelle 2 beziehungsweise dem ersten Bogenentladung-Löschungsschaltkreis 2a aus, um auf diese Weise die erste Gegenmaßnahme zu bewirken. Dabei kann es sich bei einer "Gegenmaßnahme" entweder um das Abschalten der Leistungsquelle 2, d.h. eine Unterbrechung der Plasma-Leistungsversorgung, oder um ein Umpolen der Leistungsquelle 2 mittels eines Bogenentladung-Löschungsschaltkreises 2a, 2b handeln, um auf diese Weise die Bogenentladung noch effizienter löschen zu können.

Die erste Reaktionszeit t5 kann im Rahmen der vorliegenden Erfindung entweder über den Eingang 8e der erfindungsgemäßen Bogenentladungs-Erkennungseinrichtung 3 vorgegeben werden, wie in Figur 1 dargestellt, beispielsweise durch einen Anwender mittels eines geeigneten Eingabegerätes (nicht gezeigt). Alternativ kann ein Einstellen der ersten Reaktionszeit t5 auch in Abhängigkeit von Prozessparametern des Plasmaprozesses PP erfolgen, die mittels der Sensoranordnung 7b bestimmt und an die Steuereinheit 7 übertragen werden. Mittels der variablen ersten Reaktionszeit t5 lässt sich auf ein optimales Bearbeitungsergebnisses des Plasmaprozesses PP hinwirken. Wenn nach Ablauf der ersten Reaktionszeit t5 die zuvor erkannte und durch das Überwachungssignal MS angezeigte Bogenentladung nicht mehr vorhanden ist, kann das bedeuten, dass es sich bei der erkannten Bogenentladung um eine selbstverlöschende Bogenentladung, d.h. einen Short-Arc, gehandelt hat. Erfindungsgemäß wird also auch auf einem derartigen Short-Arc mit einer entsprechenden ersten Gegenmaßnahme reagiert, worauf weiter unten anhand der Fig. 2 noch detaillierter eingegangen wird.

Die erste Gegenmaßnahme wird während einer zeitlichen Dauer t2 durchgeführt, die vorliegend auch als zweite Zeit bezeichnet wird und die über den Eingang 8b vorgebbar, das heißt einstellbar ist. Anschließend - also nach Beendigung der ersten Gegenmaßnahme - wartet die erfindungsgemäße Bogenentladungs-Erkennungseinrichtung 3 nach Maßgabe der Steuereinheit 7 während einer über den Eingang 8a einstellbaren Verzögerungszeit t1, bevor mittels der Überwachungseinheit 5 erneut die Kenngröße KG des Plasmaprozesses PP überprüft wird. Wenn entsprechend nach Ablauf der Verzögerungszeit t1 das Steuersignal MS weiterhin eine Bogenentladung anzeigt, d.h. MS = 1, erzeugt die Steuereinheit 7 (ggf. nach Ablauf einer zweiten Reaktionszeit t5'; siehe unten) ein zweites, von dem ersten Steuersignal SS1 verschiedenes, zweites Steuersignal SS2 und gibt dieses über den Ausgang 9 an die Leistungsquelle 2 beziehungsweise an den zweitem Bogenentladung-Löschungsschaltkreis 2b aus. Durch dieses zweite Steuersignal SS2 wird erfindungsgemäß eine zweite, gemäß dem vorliegenden Ausführungsbeispiel von der ersten Gegenmaßnahme verschiedene Gegenmaßnahme zum Unterdrücken der Bogenentladung bewirkt, wie weiter oben bereits ausführlich dargestellt. Mit anderen Worten: Wenn nach Ablauf der Verzögerungszeit t1 wiederum eine Bogenentladung erkannt wird, handelt es sich dabei wahrscheinlich um einen nicht selbstverlöschenden Hard-Arc, auf den mit einer speziellen zweiten Gegenmaßnahme reagiert wird. Dabei unterscheiden sich die ersten und zweiten Gegenmaßnahmen vorteilhafter Weise hinsichtlich ihrer jeweiligen Durchführungszeit, wobei insbesondere die einstellbare zweite Zeit t2, während der die erste Gegenmaßnahme durch das Steuersignal SS1 bewirkt ist, kürzer ist als eine einstellbare dritte Zeit t3, während der die zweite Gegenmaßnahme durch das Steuersignal SS2 bewirkt ist.

Auch die zweite Gegenmaßnahme wird entsprechend der ersten Gegenmaßnahme erst nach Verstreichen einer entsprechenden zweiten Reaktionszeit t5' durchgeführt, um auf diese Weise ein Bearbeitungsergebnis des Plasmaprozesses PP zu optimieren. Mit anderen Worten: nachdem nach Ablauf der Verzögerungszeit t1 erneut eine Bogenentladung erkannt wurde, erzeugt die Steuereinheit 7 das zweite Steuersignal SS2 erst nach Ablauf der zweiten Reaktionszeit t5'. Auch die zweite Reaktionszeit t5' kann entsprechend der ersten Reaktionszeit t5 automatisch oder durch einen Anwender, das heißt über den Eingang 8e einstellbar sein.

Die einstellbare Verzögerungszeit oder erste Zeit t1 sowie die einstellbaren zweiten und dritten Zeiten t2, t3 sind gemäß der Darstellung in Fig. 1 - wie bereits gesagt - über jeweilige Eingänge 8a - c in die Steuereinheit 7 ein- und damit vorgebbar. Alternativ können jedoch alle diese Zeiten auch automatisch in Abhängigkeit von durch die Sensoranordnung 7b bestimmten Prozessparametern des Plasmaprozesses PP eingestellt werden, wie weiter oben bereits exemplarisch beschrieben wurde.

Über den vierten Eingang 8d der Steuereinheit 7 in Fig. 1 sind noch vierte Zeiten t4, t4' ein- bzw. vorgebbar, auf die weiter unten bei Erläuterung der Fig. 2 detailliert eingegangen wird. Diese und alle weiter oben bereits erwähnten Eingaben können gemeinsam mit standardmäßig vorgesehenen Grundeinstellungen für die entsprechenden Größen in dem Speichermittel 7a gespeichert sein. Vorzugsweise handelt es sich bei dem Speichermittel 7a um einen nicht flüchtigen Speicher, so dass die entsprechenden Eingaben beziehungsweise Einstellungen auch bei fehlender Energieversorgung erhalten bleiben.

Fig. 2 zeigt ein Zeitablaufdiagramm für Signale innerhalb der Plasma-Leistungsversorgung 1 aus Fig. 1 gemäß einer Ausgestaltung der vorliegenden Erfindung. Die Fig. 2 ist in vier Teile a) bis d) unterteilt, wobei Teil a) exemplarisch den Signalverlauf der elektrischen Kenngröße KG (vgl. Fig. 1), Teil b) einen Signalverlauf des Überwachungssignals MS, Teil c) einen Signalverlauf des ersten Steuersignals SS1 und Teil d) einen Signalverlauf des zweiten Steuersignals SS2 darstellt. Des Weiteren bezeichnet t in Fig. 2 die Zeit und U_{Plasma} eine Plasmaspannung des betrachteten Plasmaprozesses, die vorliegend mit einer durch eine als Gleichspannungsquelle ausgebildete Leistungsquelle 2 (Fig. 1) gelieferten Spannung gleichzusetzen ist.

Wie der Fig. 2 zu entnehmen ist, kommt es bei ① zu einem Spannungseinbruch des Plasmaprozesses, der durch eine Bogenentladung bewirkt ist. Vorliegend handelt es sich dabei um einen Short-Arc, der innerhalb einer Zeit t < t5 von selbst wieder verlischt, wie in Fig. 2 bei a) zu entnehmen ist. Mit anderen Worten: Vor Erreichen des Zeitpunkts ②, welcher den Ablauf der ersten Reaktionszeit t5 markiert, wechselt das Überwachungssignal MS (Fig. 1) von einem hohen Logikpegel MS = 1 zurück auf einen niedrigen Logikpegel MS = 0. Dennoch bewirkt die Steuereinheit 7 (Fig. 1) zum Zeitpunkt ② für eine Zeit t2, d.h. bis zum Zeitpunkt ③ ein Umpolen der Plasmaspannung durch den ersten Bogenentladung-Löschungsschaltkreis 2a. Signalverläufe der entsprechenden Steuersignale sind in Fig. 2 bei b) und c) zu entnehmen.

Kurz nachdem die Plasmaspannung, wie bei a) gezeigt, zum Zeitpunkt ① einbricht, d.h. bei Unterschreiten einer bestimmten, nicht gezeigten Spannungsschwelle, gibt die Überwachungseinheit 5 (Fig. 1) das Überwachungssignal MS auf einem hohen Logikpegel MS = 1 aus. Zum Zeitpunkt ② ist die erste Reaktionszeit t5 abgelaufen, sodass die Steuereinheit 7 - wie bereits beschrieben - gemäß Darstellung bei c) das erste Steuersignal SS1 = 1 ausgibt. Dies geschieht während der zweiten Zeit t2, während gemäß der Darstellung in Fig. 2 ein Umpolen der Plasmaspannung als erste Gegenmaßnahme bewirkt ist. Der Zustand dauert bis zum Zeitpunkt ③, in dem die Steuereinheit 7 das erste Steuersignal SS1 gemäß der Darstellung bei c) wieder auf einen niedrigen Logikpegel SS1 = 0 zurückschaltet. Bei b) in Fig. 2 ist gestrichelt noch ein Zustand des Überwachungssignals MS während der zwischen ② und ③ ergriffenen ersten Gegenmaßnahme zur Unterdrückung der Bogenentladung dargestellt. Dieser Signalverlauf ist jedoch für das Erzeugen des ersten Steuersignals SS1 nicht relevant. Mit anderen Worten: die Steuereinheit 7 muss entsprechend programmiert sein, sodass sie auf eine Arc-Erkennung seitens der Überwachungseinheit 5, d.h.

MS = 1, die von einer Gegenmaßnahme ausgelöst wurde, nicht mit einer erneuten Gegenmaßnahme reagiert.

Im rechten Teil der Fig. 2 sind entsprechende Signalverläufe für einen Fall gezeigt, bei dem es sich bei der erkannten Bogenentladung um einen nicht selbstverlöschenden Hard-Arc handelt, bei dem die zwischen den Zeitpunkten ② und ③ ergriffene erste Gegenmaßnahme noch nicht zu einem vollständigen Löschen der Bogenentladung geführt hat, so dass eine entsprechende Beeinträchtigung des Plasmaprozesses PP beziehungsweise dessen Bearbeitungsergebnisses zu befürchten ist. Dies ist bei a) in Fig. 2 dadurch gezeigt, dass der zu einem Zeitpunkt ④ auftretende Spannungsabfall bis wenigstens zum Zeitpunkt ⑤ andauert, so dass es zu keinem selbstständigen Erlöschen der anliegenden Bogenentladung kommt. Häufig liegt der Zeitpunkt ④ abweichend von der exemplarischen Darstellung in Fig. 2 unmittelbar nach Zeitpunkt ③. Bei b) ist in Fig. 2 wiederum der entsprechende Signalverlauf des Überwachungssignals MS der Überwachungseinheit 5 (Fig. 1) gezeigt. Entscheidend ist dabei, dass das Überwachungssignal MS zum Zeitpunkt ⑤, das heißt bei erneutem Überprüfen der Kenngröße KG durch die Überwachungseinheit 5 nach Verstreichen der Verzögerungszeit t1 erneut einen hohen Logikpegel MS = 1 aufweist.

In diesem Zusammenhang kann abweichend von der konkreten Darstellung in Fig. 2 vorgesehen sein, dass die Überwachungseinheit 5 (Fig. 1) zwar bereits zum Zeitpunkt ④ ein entsprechendes Signal MS = 1 ausgibt, dieses jedoch erst zur Zeit ⑤ durch die Steuereinheit 7 bewertet wird - je nachdem welche der beiden Einheiten (Überwachungseinheit bzw. Steuereinheit) mit der notwendigen Intelligenz ausgestattet ist.

Im Zeitpunkt ⑤ wird das erste Steuersignal SS1 nicht aktiviert, sondern auf einem niedrigen Logikpegel SS1 = 0 gehalten (vgl. c) in Fig. 2). Dafür wird, wie bei d) in Fig. 2 gezeigt, durch die Steuereinheit 7 (Fig. 1) nach Ablauf der zweiten Reaktionszeit t5' das zweite Steuersignal SS2 = 1 im Zeitpunkt ⑥ erzeugt und ausgegeben. Dies geschieht während einer dritten Zeit t3, wobei gilt, dass t3 > t2, wie auch der Fig. 2 im oberen Bereich zu entnehmen ist. Das Erzeugen und Ausgeben des zweiten Steuersignals SS2 = 1 während der Zeit t3 zwischen den Zeitpunkten ⑥ und ⑦ bewirkt die zweite Gegenmaßnahme zum Unterdrücken der Bogenentladung, um entsprechend angemessen auf das Auftreten von nicht selbstverlöschenden Hard-Arcs zu reagieren.

Bei b) ist in Fig. 2 wiederum mittels einer gestrichelten Linie der weitere Verlauf des Überwachungssignals MS gezeigt, der jedoch nach dem Zeitpunkt ⑥ für das Erzeugen insbesondere des Steuersignals SS2 ohne besonderen Belang ist.

In Fig. 2 sind bei a) symbolisch mittels schraffierter Balken weitere Zeiten bzw. Zeitintervalle t4, t4' dargestellt, die auch als vierte Zeiten bezeichnet werden und deren Wert bzw. Dauer über den bereits erwähnten vierten Eingang 8d der Steuereinheit 7 gemäß Fig. 1 ein- bzw. vorgebbar ist. Durch das Vorgeben der vierten Zeiten t4, t4' lässt sich bei einer besonderen Ausgestaltung der vorliegenden Erfindung bewirken, dass nach einem erfolgten Erkennen eines Spannungsabfalls, d.h. einer Bogenentladung bzw. des entsprechenden Ansprechens der Überwachungseinheit 5 (Fig. 1), wie bei b) in Fig. 2 gezeigt, bis zum Ablauf der Zeit t4 kein weiteres erstes Steuersignal SS1 (vgl. c) in Fig. 4) und bis zum Ablauf der Zeit t4' kein weiteres zweites Steuersignal SS2 erzeugt werden kann. Dies wäre in Abwandlung der Darstellung in Fig. 2 beispielsweise dann von Belang, wenn es erst nach Ablauf der Zeit t1, jedoch vor Ablauf der Zeit t4 zu einem weiteren Spannungsabfall käme (in Fig. 2 nicht gezeigt). Dann würde zwar das bei b) in Fig. 2 gezeigte Überwachungssignal MS wiederum das Erkennen einer Bogenentladung anzeigen, allerdings würde das erste Steuersignal SS1 analog zur Darstellung bei c) in Fig. 2 auf einem niedrigen Logikpegel verbleiben, obwohl es sich bei der bekannten Bogenentladung um einen weiteren Short-Arc handelt. Dies liegt daran, dass ein betreffender Zeitpunkt, beispielsweise also der Zeitpunkt ⑥ zum Auslösen der entsprechenden ersten Gegenmaßnahme noch in das nach Maßgabe der Zeit t4 "gesperrte" Zeitintervall fiele, sodass kein erstes Steuersignal SS1 = 1 erzeugt und ausgegeben würde. Entsprechendes gilt gemäß Fig. 2 für das Erzeugen des zweiten Steuersignals SS2 hinsichtlich der Zeit t4', obwohl nicht explizit dargestellt.

Durch das einstellbare Vorgeben der weiteren, vierten Zeiten t4, t4' innerhalb derer auf weitere erkannte Arcs nicht reagiert wird, kann die Bearbeitungsrate des betreffenden Plasmaprozesses erhöht werden, wobei entsprechend gelten muss, dass t4 > t1, t5 und t4' > t1, t5'.

Alternativ können auch die vierten Zeiten der t4, t4 automatisch in Abhängigkeit von Prozessparametern des Plasmaprozesses PP (Fig. 1) eingestellt beziehungsweise angepasst werden, um auf diese Weise ein optimales Bearbeitungsergebnis zu erzielen.

Vorteilhafter Weise liegt die zweite Zeit t2, während der erfindungsgemäß auf einen erkannten Short-Arc reagiert wird, im Bereich von 0,01 bis 10 µs. Dementsprechend ist die dritte Zeit t3 größer als die zweite Zeit t2, d.h. t3 > t2. Für die vierten Zeiten t4 gilt - wie gesagt -, dass t4 > t1, t5 und t4' > t1, t5'.

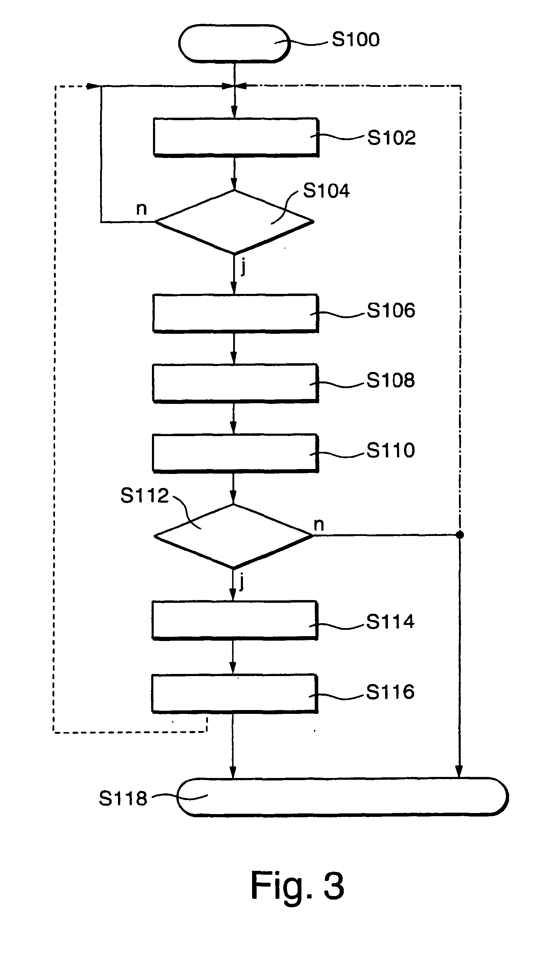

Fig. 3 zeigt ein Flussdiagramm zur Darstellung einer Ausgestaltung des erfindungsgemäßen Verfahrens zum Betreiben eines Plasmaprozesses. Das erfindungsgemäße Verfahren beginnt mit Schritt S100. In einem anschließenden Schritt S102 erfolgt die Überwachung der elektrischen Kenngröße, d.h. der Spannung, des Stroms oder der Leistung oder eines externen Signals, wie vorstehend bereits ausführlich beschrieben.

Anschließend wird in Schritt S104 überprüft, ob anhand der in Schritt S102 überwachten Kenngröße das Auftreten einer Bogenentladung erkennbar ist. Ist dies nicht der Fall (n), kehrt das Verfahren nach Schritt S102 zurück. Wird die Abfrage in Schritt S104 jedoch bejaht (j), so wird während des nachfolgenden Schritts S106 zunächst die erste Reaktionszeit abgewartet, wie vorstehend beschrieben. Anschließend wird in Schritt S108 das entsprechende Steuersignal zum Bewirken der ersten Gegenmaßnahme während einer vorgegebenen (zweiten) Zeit erzeugt (sofern nicht ein eventuell zuvor initialisiertes Zeitintervall zum Blockieren von Reaktionen auf einen Short-Arc (viertes Zeitintervall) aktiv ist; nicht dargestellt). Anschließend wird in Schritt S110 das Verstreichen der Verzögerungszeit abgewartet. Wird in einem folgenden Schritt S112 weiterhin eine Bogenentladung erkannt (j), so handelt es sich voraussichtlich um einen Hard-Arc, und nach Abwarten der zweiten Reaktionszeit (Schritt S114) erfolgt in Schritt S116 während einer vorgegebenen (dritten) Zeit eine entsprechende zweite Gegenmaßnahme, d.h. eine Unterbrechung oder ein Umpolen der Plasma-Leistungsversorgung (sofern nicht ein eventuell zuvor initialisiertes Zeitintervall zum Blockieren von Reaktionen auf einen Hard-Arc (viertes Zeitintervall) aktiv ist). Anschließend endet das Verfahren in Schritt S118 oder wird in Schritt S102 fortgesetzt (gestrichelte Linie in Fig. 3).

Wird die Abfrage in Schritt S112 verneint (n), d.h. nach Ablauf der Verzögerungszeit ist keine Bogenentladung mehr vorhanden oder keine neue Bogenentladung entstanden, so endet das Verfahren unmittelbar mit Schritt S118 oder wird mit Schritt S102 fortgesetzt (strichpunktierte Linie in Fig. 3).

Ausgestaltungen der vorliegenden Erfindung sind anwendbar auf Plasma-Leistungsversorgungen, die Gleichspannung an ein Plasma liefern, wie in den Beispielen beschrieben. Darüber hinaus ist die Erfindung auch auf Plasma-Leistungsversorgungen anwendbar, die eine Wechselspannung an das Plasma liefern.

Dabei sind die Begriffe "Verzögerungszeit" bzw. "erste Zeit", "zweite Zeit", "dritte Zeit", "vierte Zeit", "Reaktionszeit" und "Timer-Einheit", die zur Beschreibung der vorliegenden Erfindung verwendet werden, sehr weit auszulegen und insbesondere über eine jeweilige Funktion definiert.

Alternativ zu einer fest vorgegebenen Zeit kann die jeweilige Zeit auch automatisch einstellbar sein, z.B. abhängig von der Rate der erkannten Short- oder Hard-Arcs über einen vorgebbaren Zeitraum - wie vorstehend bereits eingehend beschrieben. Sie kann auch variabel sein in Abhängigkeit von einem oder mehreren externen Signalen, die an einem oder mehreren Eingangsanschlüssen (nicht gezeigt) der Plasma-Leistungsversorgung anliegen, um vom Anwender in eine automatische Abhängigkeit seiner Messungen oder Steuerungen eingebunden zu werden, z.B. einem Signal, welches einen Gasdruck oder eine Art von Gasgemisch in dem Plasmaprozess PP anzeigt und entsprechend über die Sensoranordnung 7b gemäß Fig. 1 bestimmt werden kann.

Zusätzlich zu der automatischen Einstellung der Zeit kann es für den Anwender möglich sein, eine maximale Zeit vorzuwählen, die nicht überschritten wird, auch wenn die automatische Zeiteinstellung eine längere Dauer vorsehen würde. Zusätzlich kann eine minimale Zeit vorwählbar sein, die nicht unterschritten wird, auch wenn die automatische Zeiteinstellung eine kürzere Dauer vorsehen würde. Auch derartige Einstellungen durch den Anwender können über die weiter oben beschriebenen Eingänge 8a - e der erfindungsgemäßen Bogenentladungs-Erkennungseinrichtung 3 erfolgen. In dieser Vielfältigkeit der Einstellmöglichkeiten liegt ein besonderer Vorteil dieser Erfindung. Bisher waren alle Bogenentladungs-Erkennungseinrichtungen in dieser Hinsicht beschränkt und boten dem Anwender keine Möglichkeiten, diese Zeiten variabel zu einzustellen. Mit der vorliegenden Erfindung hat der Anwender die Möglichkeit, die Bogenentladungs-Erkennungseinrichtung in vielfacher Hinsicht besser auf seine Prozesse abzustimmen und die Bearbeitungsrate sowie die Bearbeitungsqualität gleichzeitig hoch zu halten.

Bei der Vielzahl der Einstellungsmöglichkeiten ist es vorteilhaft, dem Anwender einen oder mehrere Datensätze von besonders vorteilhaften Einstellungen zur Verfügung zu stellen, unter denen er in einfacher Weise auswählen kann. Vorteilhafter Weise besitzt die erfindungsgemäße Bogenentladungs-Erkennungseinrichtung zu diesem Zweck das bereits beschriebene Speichermittel 7a zum Speichern eines oder mehrerer Sätze von voreingestellten Parametern, welche die einstellbaren Zeiten und zum Bewerten der Kenngröße erforderliche Schwellwerte auf sinnvolle Werte festlegen, damit ein Betrieb ohne Verzögerung möglich ist. Vorteilhafter Weise besitzt eine Ausgestaltung der erfindungsgemäßen Bogenentladungs-Erkennungseinrichtung eine Möglichkeit für den Anwender, solche Datensätze einzugeben bzw. zu laden und abzuspeichern, wie sie beispielsweise über die beschriebenen Eingänge 8a - e in Verbindung mit dem Speichermittel 7a bereitgestellt wird. Vorteilhafter Weise ist das Speichermittel 7a zu diesem Zweck als nicht flüchtiger Speicher ausgebildet, welches die Datensätze speichert, auch wenn die Bogenentladungs-Erkennungseinrichtung vollständig von jeder Stromversorgung getrennt ist.

Bei der Vielzahl existierender Einstellungsmöglichkeiten ist es zu dem vorteilhaft, dem Anwender in Weiterbildung der Erfindung einen oder mehrere Datensätze von besonders vorteilhaften Einstellungen zur Verfügung zu stellen, unter denen er einfach auswählen kann. Vorteilhafter Weise besitzt eine weitere Ausgestaltung der erfindungsgemäßen Plasma-Leistungsversorgung - vorzugsweise in dem Speichermittel 7a - einen oder mehrere Sätze von voreingestellten Parametern, die die einstellbaren Zeiten und Schwellwerte auf sinnvolle Werte festlegen, damit ein Betrieb ohne Verzögerung möglich ist. Vorteilhafter Weise besitzt die Plasma-Leistungsversorgung analog zu der weiter oben detailliert beschriebenen Bogenentladungs-Erkennungseinrichtung eine Möglichkeit, solche Datensätze durch den Anwender abzuspeichern. Vorteilhafter Weise werden diese Datensätze in einem nichtflüchtigen Speicher abgelegt, der die Daten speichert, auch wenn die Plasma-Leistungsversorgung vollständig von jeder Stromversorgung getrennt ist.

Weiterhin besteht die Gefahr, das der Anwender Zeiten bzw. entsprechende Werte eingibt, die sinnlos sind oder dazu führen können, dass die Plasma-Leistungsversorgung nicht arbeitet, weil z.B. eine Zeit viel zu gering oder viel zu groß eingestellt wurde. Das könnte dazu führen, dass kein Signal am Ausgang der Bogenentladungs-Erkennungseinrichtung verfügbar ist. Vorteilhafter Weise wird der Anwender bei dem Versuch, Daten einzugeben, die sinnlos sind oder für den Betrieb schädlich sein können, mit einer Warnmeldung auf die möglichen Gefahren hingewiesen, wozu eine erfindungsgemäße Vorrichtung neben den genannten Eingabemitteln auch entsprechende Ausgabe- oder Anzeigemittel (nicht gezeigt) zum Ausgeben der Warnmeldung aufweist. Völlig unsinnige Einstellungen können in Weiterbildung der vorliegenden Erfindung auch unterbunden, das heißt nicht zugelassen werden, beispielsweise indem die Steuereinheit 7 (Fig. 1) entsprechende Eingaben erkennt und nicht annimmt.

Die überwachte Kenngröße ist - wie gesagt - vorzugsweise eine elektrische Kenngröße, wie in den Beispielen beschrieben. Sie kann aber auch eine beliebige andere geeignete Kenngröße aus dem Bereich des Plasmaprozesses sein.

## Patentansprüche

1. Verfahren zum Erkennen von Bogenentladungen in einem Plasmaprozess (PP), bei dem zum Erkennen auftretender Bogenentladungen in dem Plasma mindestens eine Kenngröße (KG) des Plasmaprozesses überwacht wird und bei dem nach Erkennen einer Bogenentladung eine erste Gegenmaßnahme zum Unterdrücken von Bogenentladungen durchgeführt wird, **dadurch gekennzeichnet, dass** nach Beendigung der ersten Gegenmaßnahme während einer variablen Verzögerungszeit (t1) abgewartet und anschließend in dem Fall, dass nach Ablauf der variablen Verzögerungszeit (t1) eine Bogenentladung erkannt wird, eine zweite Gegenmaßnahme zum Unterdrücken von Bogenentladungen durchgeführt wird.

2. Verfahren nach Anspruch 1, **dadurch gekennzeichnet, dass** die Verzögerungszeit (t1) in Abhängigkeit von Prozessparametern des Plasmaprozesses (PP) eingestellt wird.

3. Verfahren nach einem der vorhergehenden Ansprüche, **dadurch gekennzeichnet, dass** ein Einstellen der Verzögerungszeit (t1) automatisch erfolgt.

4. Verfahren nach einem der vorhergehenden Ansprüche, **dadurch gekennzeichnet, dass** sich die erste Gegenmaßnahme von der zweiten Gegenmaßnahme unterscheidet.

5. Verfahren nach einem der vorhergehenden Ansprüche, **dadurch gekennzeichnet, dass** die erste Gegenmaßnahme während einer zweiten variablen Zeit (t2) durchgeführt wird.

6. Verfahren nach einem der vorhergehenden Ansprüche, **dadurch gekennzeichnet, dass** die zweite variable Zeit (t2) durch den Anwender einstellbar ist.

7. Verfahren nach einem der vorhergehenden Ansprüche, **dadurch gekennzeichnet, dass** die zweite Zeit (t2) in Abhängigkeit von Prozessparametern des Plasmaprozesses automatisch eingestellt wird.

8. Verfahren nach einem der vorhergehenden Ansprüche **dadurch gekennzeichnet, dass** die zweite Zeit (t2) zwischen 0,01 und 10 µs beträgt.

9. Verfahren nach einem der vorhergehenden Ansprüche, **dadurch gekennzeichnet, dass** als erste Gegenmaßnahme ein Unterbrechen oder ein Umpolen einer Plasma-Leistungsversorgung (1) durchgeführt wird.

10. Verfahren nach einem der vorhergehenden Ansprüche, **dadurch gekennzeichnet, dass** die zweite Gegenmaßnahme während einer dritten variablen Zeit (t3) durchgeführt wird.

11. Verfahren nach einem der vorhergehenden Ansprüche, **dadurch gekennzeichnet, dass** die dritte variable Zeit (t3) durch den Anwender einstellbar ist.

12. Verfahren nach einem der vorhergehenden Ansprüche, **dadurch gekennzeichnet, dass** die dritte Zeit (t3) in Abhängigkeit von Prozessparametern des Plasmaprozesses automatisch eingestellt wird.

13. Verfahren nach einem der vorhergehenden Ansprüche, **dadurch gekennzeichnet, dass** als zweite Gegenmaßnahme ein Unterbrechen oder ein Umpolen einer Plasma-Leistungsversorgung (1) durchgeführt wird.

14. Verfahren nach einem der vorhergehenden Ansprüche, **dadurch gekennzeichnet, dass** die dritte Zeit (t3) länger als die zweite Zeit (t2) und vorzugsweise länger als 10 µs ist.

15. Verfahren nach einem der vorhergehenden Ansprüche, **dadurch gekennzeichnet, dass** während der Verzögerungszeit (t1) keine Reaktion auf weitere erkannte Bogenentladungen erfolgt.

16. Verfahren nach einem der vorhergehenden Ansprüche, **dadurch gekennzeichnet, dass** während einer jeweiligen vierten Zeit (t4, t4') keine weiteren ersten und/oder zweiten Gegenmaßnahmen durchgeführt werden.

17. Verfahren nach einem der vorhergehenden Ansprüche, **dadurch gekennzeichnet, dass** das Verfahren zum Steuern des Betriebs einer Plasma-Leistungsversorgung (1) eingesetzt wird.

18. Verfahren nach einem der vorhergehenden Ansprüche, **dadurch gekennzeichnet, dass** mindestens eine elektrische Kenngröße (KG) des Plasmaprozesses überwacht wird.

19. Verfahren nach einem der vorhergehenden Ansprüche, **dadurch gekennzeichnet, dass** die ersten und zweiten Gegenmaßnahmen von verschiedenen Bogenentladung-Löschungsschaltkreisen (2a, 2b) durchgeführt werden.

20. Verfahren nach einem der vorhergehenden Ansprüche, **dadurch gekennzeichnet, dass** die ersten und zweiten Gegenmaßnahmen jeweils nach Ablauf einer variablen Reaktionszeit (t5, t5') ab Erkennen einer Bogenentladung durchgeführt werden.

21. Bogenentladungs-Erkennungseinrichtung (3) zum Erkennen von Bogenentladungen in einem Plasmaprozess (PP) anhand mindestens einer Kenngröße (KG) des Plasmaprozesses, aufweisend:
- eine Überwachungseinheit (5) zum Überwachen der mindestens einen Kenngröße, die zum Erzeugen und Ausgeben eines Überwachungssignals (MS) bei Erkennen einer Bogenentladung ausgebildet ist; und
- eine Steuereinheit (7), die dazu ausgebildet ist, in Abhängigkeit von dem Überwachungssignal (MS) wenigstens ein Steuersignal (SS1, SS2) zum Steuern einer jeweiligen Gegenmaßnahme zum Unterdrücken der Bogenentladung zu erzeugen;
**dadurch gekennzeichnet, dass** die Steuereinheit (7) dazu ausgebildet ist, nach Beendigung einer ersten Gegenmaßnahme während einer variablen Verzögerungszeit (t1) abzuwarten und nach Ablauf der variablen Verzögerungszeit (t1) in Abhängigkeit von dem Überwachungssignal (MS) ein Steuersignal (SS2) zum Steuern einer zweiten Gegenmaßnahme zu erzeugen.

22. Bogenentladungs-Erkennungseinrichtung (3) nach Anspruch 21, **dadurch gekennzeichnet, dass** die Verzögerungszeit (t1) in Abhängigkeit von Prozessparametern des Plasmaprozesses (PP) automatisch einstellbar ist.

23. Bogenentladungs-Erkennungseinrichtung (3) nach Anspruch 21, **dadurch gekennzeichnet, dass** die Verzögerungszeit (t1) durch einen Anwender einstellbar ist.

24. Bogenentladungs-Erkennungseinrichtung (3) nach einem der Ansprüche 21 bis 23, **dadurch gekennzeichnet, dass** die Steuereinheit (7) zum Ausgeben eines ersten Steuersignals (SS1) zum Steuern der ersten Gegenmaßnahme während einer zweiten Zeit (t2) ausgebildet ist.

25. Bogenentladungs-Erkennungseinrichtung (3) nach Anspruch 24, **dadurch gekennzeichnet, dass** die zweite Zeit (t2) einstellbar ist und insbesondere zwischen 0,01 und 10 µs beträgt.

26. Bogenentladungs-Erkennungseinrichtung (3) nach Anspruch 24 oder 25, **dadurch gekennzeichnet, dass** die zweite Zeit (t2) automatisch in Abhängigkeit von Prozessparametern des Plasmaprozesses (PP) oder durch einen Anwender einstellbar ist.

27. Bogenentladungs-Erkennungseinrichtung (3) nach einem der Ansprüche 21 bis 26, **dadurch gekennzeichnet, dass** die Steuereinheit (7) zum Ausgeben des zweiten Steuersignals (SS2) während einer dritten Zeit (t3) ausgebildet ist.

28. Bogenentladungs-Erkennungseinrichtung (3) nach Anspruch 27, **dadurch gekennzeichnet, dass** die dritte Zeit (t3) einstellbar ist, insbesondere auf Werte größer als die zweite Zeit (t2).

29. Bogenentladungs-Erkennungseinrichtung (3) nach Anspruch 27 oder 28, **dadurch gekennzeichnet, dass** die dritte Zeit (t3) automatisch in Abhängigkeit von Prozessparametern des Plasmaprozesses (PP) oder durch einen Anwender einstellbar ist.

30. Bogenentladungs-Erkennungseinrichtung (3) nach einem der Ansprüche 21 bis 29, **dadurch gekennzeichnet, dass** die Steuereinheit (7) dazu ausgebildet ist, das erste Steuersignal (SS1) und/oder das zweite Steuersignal (SS2) vor Ablauf einer vierten Zeit (t4, t4') nicht erneut zu erzeugen.

31. Bogenentladungs-Erkennungseinrichtung (3) nach Anspruch 30, **dadurch gekennzeichnet, dass** die vierte Zeit (t4, t4') einstellbar ist.

32. Bogenentladungs-Erkennungseinrichtung (3) nach Anspruch 30 oder 31, **dadurch gekennzeichnet, dass** die vierte Zeit (t4, t4') für die ersten und zweiten Gegenmaßnahmen unabhängig voneinander einstellbar ist.

33. Bogenentladungs-Erkennungseinrichtung (3) nach einem der Ansprüche 30 bis 32, **dadurch gekennzeichnet, dass** die vierte Zeit (t4, t4') automatisch in Abhängigkeit von Prozessparametern des Plasmaprozesses (PP) oder durch einen Anwender einstellbar ist.

34. Bogenentladungs-Erkennungseinrichtung (3) nach einem der Ansprüche 21 bis 33, **dadurch gekennzeichnet, dass** die Überwachungseinheit (5) zum Überwachen einer elektrischen Kenngröße (KG) des Plasmaprozesses (PP) ausgebildet ist.

35. Bogenentladungs-Erkennungseinrichtung (3) nach einem der Ansprüche 21 bis 34, **gekennzeichnet durch** getrennte Bogenentladung-Löschungsschaltkreise (2a, 2b) zum Durchführen der ersten und zweiten Gegenmaßnahmen.

36. Bogenentladungs-Erkennungseinrichtung (3) nach einem der Ansprüche 21 bis 35, **dadurch gekennzeichnet, dass** die Steuereinheit (7) zum Veranlassen der ersten und zweiten Gegenmaßnahmen jeweils nach Ablauf einer variablen Reaktionszeit (t5, t5') ab Erkennen einer Bogenentladung ausgebildet ist.

37. Bogenentladungs-Erkennungseinrichtung (3) nach Anspruch 36, **dadurch gekennzeichnet, dass** die Reaktionszeit (t5, t5') automatisch in Abhängigkeit von Prozessparametern (PP) des Plasmaprozesses oder durch einen Anwender einstellbar ist.

38. Plasma-Leistungsversorgung (1) zum Versorgen eines Plasmaprozesses, **gekennzeichnet durch** eine Bogenentladungs-Erkennungseinrichtung (3) nach einem der Ansprüche 21 bis 37, wobei die Plasma-Leistungsversorgung **durch** die Steuereinheit (7) der Bogenentladungs-Erkennungseinrichtung steuerbar ist.

39. Plasma-Leistungsversorgung (1) nach Anspruch 38, **dadurch gekennzeichnet, dass** die Plasma-Leistungsversorgung als erste Gegenmaßnahme zum Unterdrücken von Bogenentladungen nach Maßgabe eines ersten Steuersignals (SS1) der Steuereinheit (7) während einer bestimmten Zeit (t2) abschaltbar oder umpolbar ist.

40. Plasma-Leistungsversorgung (1) nach Anspruch 38 oder 39, **dadurch gekennzeichnet, dass** die Plasma-Leistungsversorgung als zweite Gegenmaßnahme zum Unterdrücken von Bogenentladungen nach Maßgabe eines zweiten Steuersignals (SS2) der Steuereinheit (7) während einer weiteren bestimmten Zeit (t3) abschaltbar oder umpolbar ist.

## Claims

1. A method for the detection of arc discharges in a plasma process (PP), in which for the detection of arc discharges occurring in the plasma at least one parameter (KG) of the plasma process is monitored, and in which after detection of an arc discharge a first countermeasure for the suppression of arc discharges is executed, **characterised in that** after completion of the first countermeasure a variable delay time (t1) is allowed to elapse and subsequently in the event that after elapse of the variable delay time (t1) an arc discharge is detected, a second countermeasure for the suppression of arc discharges is executed.

2. The method according to Claim 1,
**characterised in that** the delay time (t1) is adjusted as a function of process parameters of the plasma process (PP).

3. The method according to one of the previous claims,
**characterised in that** an adjustment of the delay time (t1) takes place automatically.

4. The method according to one of the previous claims,
**characterised in that** the first countermeasure differs from the second countermeasure.

5. The method according to one of the previous claims, **characterised in that** the first countermeasure is executed during a second variable period of time (t2).

6. The method according to one of the previous claims, **characterised in that** the second variable period of time (t2) can be adjusted by the user.

7. The method according to one of the previous claims, **characterised in that** the second period of time (t2) is automatically adjusted as a function of process parameters of the plasma process.

8. The method according to one of the previous claims, **characterised in that** the second period of time (t2) is between 0.01 and 10 µs in duration.

9. The method according to one of the previous claims, **characterised in that** an interruption or a reversal in polarity of a plasma power supply (1) is executed as a first countermeasure.

10. The method according to one of the previous claims, **characterised in that** the second countermeasure is executed during a third variable period of time (t3).

11. The method according to one of the previous claims, **characterised in that** the third variable period of time (t3) can be adjusted by the user.

12. The method according to one of the previous claims, **characterised in that** the third period of time (t3) is automatically adjusted as a function of process parameters of the plasma process.

13. The method according to one of the previous claims, **characterised in that** an interruption or a reversal in polarity of a plasma power supply (1) is executed as a second countermeasure.

14. The method according to one of the previous claims, **characterised in that** the third period of time (t3) is longer than the second period of time (t2) and is preferably longer than 10 µs.

15. The method according to one of the previous claims, **characterised in that** no response to any further arc discharges detected takes place during the delay time (t1).

16. The method according to one of the previous claims, **characterised in that** no further first and/or second countermeasures are executed during a respective fourth period of time (t4, t4').

17. The method according to one of the previous claims, **characterised in that** the method is used to control the operation of a plasma power supply (1).

18. The method according to one of the previous claims, **characterised in that** at least one electrical parameter (KG) of the plasma process is monitored.

19. The method according to one of the previous claims, **characterised in that** the first and second countermeasures are executed by different arc discharge extinction circuits (2a, 2b).

20. The method according to one of the previous claims,
**characterised in that** the first and second countermeasures in each case are executed after elapse of a variable response time (t5, t5') from detection of an arc discharge.

21. An arc discharge detection device (3) for the detection of arc discharges in a plasma process (PP) with the aid of at least one parameter (KG) of the plasma process, having:
- a monitoring unit (5) to monitor the at least one parameter, which is designed to generate and output a monitoring signal (MS) in the event of detection of an arc discharge; and
- a control unit (7), which is designed so as to generate as a function of the monitoring signal (MS) at least one control signal (SS1, SS2) to control a respective countermeasure for the suppression of the arc discharge,
**characterised in that** the control unit (7) is designed so as to allow a variable delay time (t1) to elapse after completion of a first countermeasure, and so as to generate as a function of the monitoring signal (MS) a control signal (SS2) to control a second countermeasure after elapse of the variable delay time (t1).

22. The arc discharge detection device (3) according to Claim 21, **characterised in that** the delay time (t1) can be automatically adjusted as a function of process parameters of the plasma process (PP).

23. The arc discharge detection device (3) according to Claim 21, **characterised in that** the delay time (t1) can be adjusted by a user.

24. The arc discharge detection device (3) according to one of the Claims 21 to 23,
**characterised in that** the control unit (7) is designed to output a first control signal (SS1) to control the first countermeasure during a second period of time (t2).

25. The arc discharge detection device (3) according to Claim 24,
**characterised in that** the second period of time (t2) is adjustable and in particular is between 0.01 and 10 µs in duration.

26. The arc discharge detection device (3) according to Claim 24 or 25,
**characterised in that** the second period of time (t2) can be automatically adjusted as a function of process parameters of the plasma process (PP) or can be adjusted by a user.

27. The arc discharge detection device (3) according to one of the Claims 21 to 26,
**characterised in that** the control unit (7) is designed to output the second control signal (SS2) during a third period of time (t3).

28. The arc discharge detection device (3) according to Claim 27,
**characterised in that** the third period of time (t3) is adjustable, in particular to values greater than the second period of time (t2).

29. The arc discharge detection device (3) according to Claim 27 or 28,
**characterised in that** the third period of time (t3) can be automatically adjusted as a function of process parameters of the plasma process (PP) or can be adjusted by a user.

30. The arc discharge detection device (3) according to one of the Claims 21 to 29,
**characterised in that** the control unit (7) is designed so as not to renew the first control signal (SS1) and/or the second control signal (SS2) before the elapse of a fourth period of time (t4, t4').

31. The arc discharge detection device (3) according to Claim 30,
**characterised in that** the fourth period of time (t4, t4') can be adjusted.

32. The arc discharge detection device (3) according to Claim 30 or 31,
**characterised in that** the fourth period of time (t4, t4') can be adjusted for the first and second countermeasures independently of each other.

33. The arc discharge detection device (3) according to one of the Claims 30 to 32,
**characterised in that** the fourth period of time (t4, t4') can be automatically adjusted as a function of process parameters of the plasma process (PP) or can be adjusted by a user.

34. The arc discharge detection device (3) according to one of the Claims 21 to 33,
**characterised in that** the monitoring unit (5) is designed to monitor an electrical parameter (KG) of the plasma process.

35. The arc discharge detection device (3) according to one of the Claims 21 to 34,
**characterised by** separate arc discharge extinction circuits (2a, 2b) to execute the first and second countermeasures.

36. The arc discharge detection device (3) according to one of the Claims 21 to 35,
**characterised in that** the control circuit (7) is designed to trigger the first and second countermeasures in each case after elapse of a variable response time (t5, t5') from detection of an arc discharge.

37. The arc discharge detection device (3) according to Claim 36,
**characterised in that** the response time (t5, t5') can be automatically adjusted as a function of process parameters of the plasma process (PP) or can be adjusted by a user.

38. A plasma power supply (1) to supply a plasma process, **characterised by** an arc discharge detection device (3) according to one of the Claims 21 to 37, wherein
the plasma power supply can be controlled by the control unit (7) of the arc discharge detection device.

39. The plasma power supply (1) according to Claim 38,
**characterised in that** the plasma power supply can be switched off or reversed in polarity as a first countermeasure for the suppression of arc discharges according to a first control signal (SS1) of the control unit (7) during a certain period of time (t2).

40. The plasma power supply (1) according to Claim 38 or 39,
**characterised in that** the plasma power supply can be switched off or reversed in polarity as a second countermeasure for the suppression of arc discharges according to a second control signal (SS2) of the control unit (7) during a further certain period of time (t3).

## Revendications

1. Procédé de détection de décharges en arc dans un procédé plasma (PP), dans lequel, pour détecter les décharges en arc qui se produisent dans le plasma, au moins une grandeur caractéristique (KG) du procédé plasma est surveillée et dans lequel, après détection d'une décharge en arc, une première contre-mesure pour supprimer les décharges en arc est effectuée, **caractérisé en ce qu'**à la fin de la première contre-mesure, on attend un temps de retard variable (t1) et ensuite, si une décharge en arc est détectée après expiration du temps de retard variable (t1), une deuxième contre-mesure pour supprimer les décharges en arc est effectuée.

2. Procédé selon la revendication 1, **caractérisé en ce que** le temps de retard (t1) est réglé en fonction de paramètres de procédé du procédé plasma (PP).

3. Procédé selon une des revendications précédentes, **caractérisé en ce que** le réglage du temps de retard (t1) est automatique.

4. Procédé selon une des revendications précédentes, **caractérisé en ce que** la première contre-mesure est différente de la deuxième contre-mesure.

5. Procédé selon une des revendications précédentes, **caractérisé en ce que** la première contre-mesure est effectuée pendant un deuxième temps variable (t2).

6. Procédé selon une des revendications précédentes, **caractérisé en ce que** le deuxième temps variable (t2) est réglable par l'utilisateur.

7. Procédé selon une des revendications précédentes, **caractérisé en ce que** le deuxième temps (t2) est réglé automatiquement en fonction de paramètres de procédé du procédé plasma.

8. Procédé selon une des revendications précédentes, **caractérisé en ce que** le deuxième temps (t2) est compris entre 0,01 et 10 µs.

9. Procédé selon une des revendications précédentes, **caractérisé en ce que** l'on effectue comme première contre-mesure une coupure ou une inversion de polarité d'une alimentation en énergie de plasma (1).

10. Procédé selon une des revendications précédentes, **caractérisé en ce que** la deuxième contre-mesure est effectuée pendant un troisième temps variable (t3).

11. Procédé selon une des revendications précédentes, **caractérisé en ce que** le troisième temps variable (t3) est réglable par l'utilisateur.

12. Procédé selon une des revendications précédentes, **caractérisé en ce que** le troisième temps (t3) est réglé automatiquement en fonction de paramètres de procédé du procédé plasma.

13. Procédé selon une des revendications précédentes, **caractérisé en ce que** l'on effectue comme deuxième contre-mesure une coupure ou une inversion de polarité d'une alimentation en énergie de plasma (1).

14. Procédé selon une des revendications précédentes, **caractérisé en ce que** le troisième temps (t3) est plus long que le deuxième temps (t2) et de préférence plus long que 10 µs.

15. Procédé selon une des revendications précédentes, **caractérisé en ce que** pendant le temps de retard (t1), il n'y a pas de réaction à d'autres décharges en arc détectées.

16. Procédé selon une des revendications précédentes, **caractérisé en ce que** pendant un quatrième temps respectif (t4, t4'), aucune autre première et/ou deuxième contre-mesure n'est effectuée.

17. Procédé selon une des revendications précédentes, **caractérisé en ce que** le procédé est utilisé pour commander le fonctionnement d'une alimentation en énergie de plasma (1).

18. Procédé selon une des revendications précédentes, **caractérisé en ce qu'**au moins une grandeur caractéristique électrique (KG) du procédé plasma est surveillée.

19. Procédé selon une des revendications précédentes, **caractérisé en ce que** les première et deuxième contre-mesures sont effectuées par des circuits d'extinction de décharges en arc (2a, 2b) différents.

20. Procédé selon une des revendications précédentes, **caractérisé en ce que** les première et deuxième contre-mesures sont effectuées dans chaque cas après expiration d'un temps de réaction variable (t5, t5') à partir de la détection d'une décharge en arc.

21. Dispositif de détection de décharges en arc (3) pour détecter des décharges en arc dans un procédé plasma (PP) à l'aide d'au moins une grandeur caractéristique (KG) du procédé plasma, présentant :
- une unité de surveillance (5) pour surveiller ladite au moins une grandeur caractéristique, qui est conçue pour générer et délivrer un signal de surveillance (MS) en cas détection d'une décharge en arc ; et
- une unité de commande (7) qui est conçue pour, en fonction du signal de surveillance (MS), générer au moins un signal de commande (SS1, SS2) pour commander une contre-mesure respective pour supprimer la décharge en arc ;
**caractérisé en ce que** l'unité de commande (7) est conçue pour, à la fin d'une première contre-mesure, attendre pendant un temps de retard variable (t1) et, après expiration du temps de retard variable (t1), en fonction du signal de surveillance (MS), générer un signal de commande (SS2) pour commander une deuxième contre-mesure.

22. Dispositif de détection de décharges en arc (3) selon la revendication 21, **caractérisé en ce que** le temps de retard (t1) est réglable automatiquement en fonction de paramètres de procédé du procédé plasma (PP).

23. Dispositif de détection de décharges en arc (3) selon la revendication 21, **caractérisé en ce que** le temps de retard (t1) est réglable par un utilisateur.

24. Dispositif de détection de décharges en arc (3) selon une des revendications 21 à 23, **caractérisé en ce que** l'unité de commande (7) est conçue pour délivrer un premier signal de commande (SS1) pour commander la première contre-mesure pendant un deuxième temps (t2).

25. Dispositif de détection de décharges en arc (3) selon la revendication 24, **caractérisé en ce que** le deuxième temps (t2) est réglable et en particulier compris entre 0,01 et 10 µs.

26. Dispositif de détection de décharges en arc (3) selon la revendication 24 ou 25, **caractérisé en ce que** le deuxième temps (t2) est réglable automatiquement en fonction de paramètres de procédé du procédé plasma (PP) ou par un utilisateur.

27. Dispositif de détection de décharges en arc (3) selon une des revendications 21 à 26, **caractérisé en ce que** l'unité de commande (7) est conçue pour délivrer le deuxième signal de commande (SS2) pendant un troisième temps (t3).

28. Dispositif de détection de décharges en arc (3) selon la revendication 27, **caractérisé en ce que** le troisième temps (t3) est réglable, en particulier à une valeur supérieure au deuxième temps (t2).

29. Dispositif de détection de décharges en arc (3) selon la revendication 27 ou 28, **caractérisé en ce que** le troisième temps (t3) est réglable automatiquement en fonction de paramètres de procédé du procédé plasma (PP) ou par un utilisateur.

30. Dispositif de détection de décharges en arc (3) selon une des revendications 21 à 29, **caractérisé en ce que** l'unité de commande (7) est conçue pour ne pas générer de nouveau le premier signal de commande (SS1) et/ou le deuxième signal de commande (SS2) avant expiration d'un quatrième temps (t4, t4').

31. Dispositif de détection de décharges en arc (3) selon la revendication 30, **caractérisé en ce que** le quatrième temps (t4, t4') est réglable.

32. Dispositif de détection de décharges en arc (3) selon la revendication 30 ou 31, **caractérisé en ce que** le quatrième temps (t4, t4') est réglable indépendamment pour les première et deuxième contre-mesures.

33. Dispositif de détection de décharges en arc (3) selon une des revendications 30 à 32, **caractérisé en ce que** le quatrième temps (t4, t4') est réglable automatiquement en fonction de paramètres de procédé du procédé plasma (PP) ou par un utilisateur.

34. Dispositif de détection de décharges en arc (3) selon une des revendications 21 à 33, **caractérisé en ce que** l'unité de surveillance (5) est conçue pour surveiller une grandeur caractéristique électrique (KG) du procédé plasma (PP).

35. Dispositif de détection de décharges en arc (3) selon une des revendications 21 à 34, **caractérisé par** des circuits d'extinction de décharges en arc (2a, 2b) séparés pour effectuer les première et deuxième contre-mesures.

36. Dispositif de détection de décharges en arc (3) selon une des revendications 21 à 35, **caractérisé en ce que** l'unité de commande (7) est conçue pour déclencher les première et deuxième contre-mesures dans chaque cas après expiration d'un temps de réaction variable (t5, t5') à partir de la détection d'une décharge en arc.

37. Dispositif de détection de décharges en arc (3) selon la revendication 36, **caractérisé en ce que** le temps de réaction (t5, t5') est réglable automatiquement en fonction de paramètres de procédé (PP) du procédé plasma ou par un utilisateur.

38. Alimentation en énergie de plasma (1) pour alimenter un procédé plasma, **caractérisée par** un dispositif de détection de décharges en arc (3) selon une des revendications 21 à 37, l'alimentation en énergie de plasma étant commandable par l'unité de commande (7) du dispositif de détection de décharges en arc.

39. Alimentation en énergie de plasma (1) selon la revendication 38, **caractérisée en ce que** l'alimentation en énergie de plasma peut être coupée ou subir une inversion de polarité pendant un temps défini (t2) en fonction d'un premier signal de commande (SS1) de l'unité de commande (7) comme première contre-mesure pour supprimer des décharges en arc.

40. Alimentation en énergie de plasma (1) selon la revendication 38 ou 39, **caractérisée en ce que** l'alimentation en énergie de plasma peut être coupée ou subir une inversion de polarité pendant un autre temps défini (t3) en fonction d'un deuxième signal de commande (SS2) de l'unité de commande (7) comme deuxième contre-mesure pour supprimer des décharges en arc.
